# EUROPEAN PATENT APPLICATION

(11) **EP 4 192 028 A1**
(43) Date of publication of application: **07.06.2023**
(21) Application number: 21857656.9
(22) Date of filing: 17.08.2021
(51) Int. Cl.: H04Q 11/00, G02B 27/28, H01S 5/00

(54) **LIGHT SOURCE, OPTICAL TRANSMISSION METHOD, AND OPTICAL INJECTION LOCKING SYSTEM**

(30) Priority: 21.08.2020 CN 202010849185
(71) Applicant: Huawei Technologies Co., Ltd., Shenzhen, Guangdong 518129 (CN)
(72) Inventor: MAO, Yuanfeng, Shenzhen, Guangdong 518129 (CN); CHENG, Yuanbing, Shenzhen, Guangdong 518129 (CN)
(74) Representative: Maiwald GmbH
(86) International application number: PCT/CN2021/112953
(87) International publication number: WO 2022/037563

(57) **Abstract**

Embodiments of this application provide a light source, an optical transmission method, and an optical injection locked system, to implement that a wavelength of output light of a laser is the same as a wavelength of injected continuous light. The light source in embodiments of this application includes: a polarization conversion apparatus, a laser, and a plurality of waveguides. The polarization conversion apparatus is configured to convert the injected continuous light into first continuous light and second continuous light, and transmit the first continuous light and the second continuous light to the laser by using different waveguides. A polarization direction of the first continuous light, a polarization direction of the second continuous light, and a polarization direction of continuous light generated by the laser are the same. The laser is configured to generate first output light and second output light based on the injected continuous light, and transmit the first output light and the second output light to the polarization conversion apparatus. A wavelength of the first output light, a wavelength of the second output light, and a wavelength of the injected continuous light are the same. The polarization conversion apparatus is further configured to multiplex and output the first output light and the second output light.

## Description

This application claims priority to Chinese Patent Application No. 202010849185.9, filed with the China National Intellectual Property Administration on August 21, 2020 and entitled "LIGHT SOURCE, OPTICAL TRANSMISSION METHOD, AND OPTICAL INJECTION LOCKED SYSTEM", which is incorporated herein by reference in its entirety.

### TECHNICAL FIELD

This application relates to the field of optical communication, and in particular, to a light source, an optical transmission method, and an optical injection locked system.

### BACKGROUND

With rapid development of optical communication technologies, a passive optical network (Passive Optical Network, PON) system is increasingly widely used in the optical communication technologies. Uplink transmission of the PON system may use a code division multiple access (Code Division Multiple Access, CDMA) manner. That is, all optical network units (Optical Network Unit, ONU) simultaneously send uplink data to an optical line terminal (Optical Line Terminal, OLT), and CDMA codes corresponding to different ONUs are different.

To avoid interference when the OLT receives signals emitted by the ONUs, all the ONUs need to emit signals of a same wavelength. This may be specifically implemented through optical injection locking. Continuous light emitted by a primary laser in the OLT needs to be injected into a secondary laser in each ONU. However, after the continuous light emitted by the primary laser is transmitted through an optical fiber, a polarization direction of the continuous light injected into the ONU may be changed due to environment changes (such as a stress and a temperature of the optical fiber). Consequently, the polarization direction of the injected continuous light is different from a polarization direction of a continuous light emitted by the secondary laser, and a wavelength of the continuous light emitted by the secondary laser is different from a wavelength of the continuous light emitted by the primary laser.

### SUMMARY

Embodiments of this application provide a light source, an optical transmission method, and an optical injection locked system, to implement that a wavelength of output light of a laser is the same as a wavelength of injected continuous light.

According to a first aspect, an embodiment of this application provides a light source, including: a polarization conversion apparatus, a laser, and a plurality of waveguides. The polarization conversion apparatus includes a first port, a second port, and a third port. The first port and the second port are coupled to the laser by using different waveguides. The polarization conversion apparatus is configured to receive injected continuous light through the third port, then, convert the injected continuous light into first continuous light and second continuous light, then, transmit the first continuous light to the laser through the first port, and transmit the second continuous light to the laser through the second port. A polarization direction of the first continuous light, a polarization direction of the second continuous light, and a polarization direction of continuous light generated by the laser are the same. The laser is configured to generate first output light and second output light based on the injected continuous light, then, transmit the first output light to the polarization conversion apparatus through the first port, and transmit the second output light to the polarization conversion apparatus through the second port. A wavelength of the first output light, a wavelength of the second output light, and a wavelength of the injected continuous light are the same. The polarization conversion apparatus is further configured to multiplex the first output light and the second output light, and output, through the third port, the first output light and the second output light after multiplexing.

In this implementation, the polarization direction of the first continuous light, the polarization direction of the second continuous light, and the polarization direction of the continuous light generated by the laser are the same. Therefore, the wavelength of the output light of the laser may be the same as the wavelength of the injected continuous light.

In some possible implementations, both the first output light and the second output light generated by the laser are continuous light. An implementation of this solution is provided, which makes this solution more practical.

In some possible implementations, both the first output light and the second output light are optical signals. The light source further includes a phase shifter (Phase Shifter, PS). One end of the PS is coupled to the laser by using a waveguide, and the other end of the PS is coupled to the first port by using a waveguide. The PS is configured to perform phase adjustment on the first output light, and transmit the first output light after phase adjustment to the polarization conversion apparatus through the first port, so that phases of the first output light and the second output light after multiplexing are synchronized. Alternatively, one end of the PS is coupled to the laser by using a waveguide, and the other end of the PS is coupled to the second port by using a waveguide. The PS is configured to perform phase adjustment on the second output light, and transmit the second output light after phase adjustment to the polarization conversion apparatus through the second port, so that phases of the first output light and the second output light after multiplexing are synchronized.

In this implementation, a phase of any optical signal output by the laser may be adjusted by using the PS, to ensure that phases of the two optical signals after multiplexing are synchronized.

In some possible implementations, the polarization conversion apparatus may be specifically a polarization splitter and rotator (Polarization Splitter and Rotator, PSR). This makes this solution more implementable.

In some possible implementations, the polarization conversion apparatus includes a polarization beam splitter (Polarization Beam Splitter, PBS) and a polarization rotator (Polarization Rotator, PR). The PBS includes the first port, the third port, and a fourth port. The PR includes the second port and a fifth port. The fourth port and the fifth port are coupled to each other by using a waveguide. The PBS is configured to convert the injected continuous light into the first continuous light and third continuous light, then, transmit the first continuous light to the laser through the first port, and transmit the third continuous light to the PR through the second port. The polarization direction of the first continuous light is orthogonal to a polarization direction of the third continuous light. The PR is configured to convert the third continuous light into second continuous light, and transmit the second continuous light to the laser.

In this implementation, the PSR may be replaced by a combination of the PBS and the PR, thereby improving expansibility of this solution.

In some possible implementations, the laser includes a first end face and a second end face, the first continuous light is transmitted to the laser from the first end face, and the second continuous light is transmitted to the laser from the second end face. It should be understood that light generated by the laser is output from the two end faces of the laser. Therefore, the light injected into the laser and the light output by the laser may share a same group of waveguides, thereby reducing a quantity of waveguides required.

In some possible implementations, the polarization conversion apparatus, the laser, and the plurality of waveguides share a same substrate. A material of the substrate is a silicon-based semiconductor material. Materials of the plurality of waveguides include at least one of silicon, silicon dioxide, or silicon nitride. Alternatively, a material of the substrate is indium phosphide (InP). Materials of the plurality of waveguides include at least one of InP, indium gallium arsenide phosphide (InGaAsP), or indium gallium aluminum arsenide (InGaAlAs). It should be understood that two waveguides configured to transmit the first continuous light and the second continuous light may be physically connected to the two end faces of the laser. The light source may be implemented by using an integrated chip, thereby further improving implementability of this solution.

In some possible implementations, the polarization conversion apparatus shares a first substrate with the plurality of waveguides, and the laser uses a second substrate. A material of the first substrate is a silicon-based semiconductor material. Materials of the plurality of waveguides include at least one of silicon, silicon dioxide, or silicon nitride. A material of the second substrate is InP. Alternatively, a material of the first substrate is InP. Materials of the plurality of waveguides include at least one of InP, InGaAsP, or InGaAlAs. A material of the second substrate is a silicon-based semiconductor material. It should be understood that two waveguides configured to transmit the first continuous light and the second continuous light cannot be physically connected to two end faces of a laser 1, but are coupled together through air. The polarization conversion apparatus and the laser may be respectively integrated into two mutually independent chips. The light source may be an integrated component that packages the two chips together, so that expansibility of this solution is further improved.

In some possible implementations, the injected continuous light is from an OLT and the light source is located in an ONU. The light source may be specifically used in a PON scenario, so that practicality of this solution is improved.

According to a second aspect, an embodiment of this application provides an optical transmission method. The method includes the following steps: first, receiving injected continuous light; next, converting the injected continuous light into first continuous light and second continuous light, and transmitting the first continuous light and the second continuous light to a laser by using different waveguides, where a polarization direction of the first continuous light, a polarization direction of the second continuous light, and a polarization direction of continuous light generated by the laser are the same; and further, multiplexing first output light and second output light that are generated by the laser based on the injected continuous light, and outputting the first output light and the second output light after multiplexing, where a wavelength of the first output light, a wavelength of the second output light, and a wavelength of the injected continuous light are the same.

In some possible implementations, both the first output light and the second output light are continuous light.

In some possible implementations, both the first output light and the second output light are optical signals. Before the multiplexing first output light and second output light, the method further includes: performing phase adjustment on the first output light or the second output light, so that phases of the first output light and the second output light after multiplexing are synchronized.

In some possible implementations, the converting the injected continuous light into first continuous light and second continuous light includes: converting the injected continuous light into the first continuous light and the second continuous light by using a PSR.

In some possible implementations, the converting the continuous light into first continuous light and second continuous light includes: converting the continuous light into the first continuous light and third continuous light by using a PBS, where the polarization direction of the first continuous light is orthogonal to a polarization direction of the third continuous light; and converting the third continuous light into the second continuous light by using a PR.

In some possible implementations, the laser includes a first end face and a second end face. The first continuous light is transmitted to the laser from the first end face. The second continuous light is transmitted to the laser from the second end face.

In some possible implementations, the injected continuous light is from an OLT and the laser is located in an ONU.

According to a third aspect, this application provides an optical injection locked system, where the system includes a first light source and a second light source. The first light source is configured to emit continuous light to the second light source. The second light source is a light source according to any one of the implementations of the first aspect.

In some possible implementations, the first light source is located in an optical line terminal OLT, and the second light source is located in an optical network unit ONU.

It may be learned from the foregoing technical solutions that embodiments of this application have the following advantages: The polarization conversion apparatus in the light source converts the injected continuous light into the first continuous light and the second continuous light, and transmits the first continuous light and the second continuous light to the laser in the light source by using the different waveguides. The polarization direction of the first continuous light, the polarization direction of the second continuous light, and the polarization direction of continuous light generated by the laser are the same. Therefore, the wavelength of the output light of the laser may be the same as the wavelength of the injected continuous light.

### BRIEF DESCRIPTION OF DRAWINGS

FIG. 1 is a schematic diagram of an application scenario of an optical injection locked system according to this application;
FIG. 2 is a schematic diagram of another application scenario of an optical injection locked system according to this application;
FIG. 3 is a schematic diagram of a first embodiment of a light source according to this application;
FIG. 4 (a) is a schematic diagram of two optical signals whose phases are inconsistent;
FIG. 4 (b) is a schematic diagram of two optical signals whose phases are consistent;
FIG. 5 is a schematic diagram of a second embodiment of a light source according to this application;
FIG. 6 is a schematic diagram of a third embodiment of a light source according to this application;
FIG. 7 is a schematic diagram of a fourth embodiment of a light source according to this application;
FIG. 8 is a schematic diagram of a cross section of a light source according to this application;
FIG. 9 is a schematic diagram of another cross section of a light source according to this application; and
FIG. 10 is a schematic diagram of an embodiment of an optical transmission method according to this application.

### DESCRIPTION OF EMBODIMENTS

Embodiments of this application provide a light source, an optical transmission method, and an optical injection locked system, to implement that a wavelength of output light of a laser is the same as a wavelength of injected continuous light. It should be noted that the terms such as "first", "second", "third", and "fourth" in the specification, claims, and accompanying drawings of this application are used to distinguish between similar objects, but not to limit a specific order or sequence. It should be understood that the foregoing terms may be exchanged under proper conditions, so that it possible to implement the described embodiments of this application in a sequence other than the content described in this application. In addition, the terms "including", "including", or any other variant thereof are intended to cover a non-exclusive inclusion. For example, a process, method, system, product, or device that includes a list of steps or units is not necessarily limited to those steps or units which are clearly listed, but may include other steps or units which are not expressly listed or inherent to such a process, method, system, product, or device.

The light source provided in this application is mainly used in the optical injection locked system. The following first describes the optical injection locked system in this application.

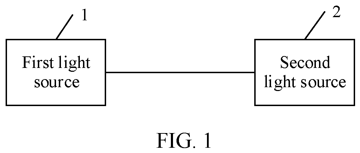

FIG. 1 is a schematic diagram of an application scenario of an optical injection locked (optical injection locked) system according to this application. The optical injection locked system includes a first light source 1 and a second light source 2. Continuous light emitted by the first light source 1 is injected into the second light source 2. An optical injection locking technology is used to enable a wavelength of continuous light emitted by the second light source 2 to be the same as a wavelength of the continuous light emitted by the first light source 1. An isolator or a circulator may be further disposed between the first light source 1 and the second light source 2, to ensure that light emitted by the first light source 1 may be unidirectionally injected into the second light source 2. It should be understood that in the optical injection locked system, the first light source 1 is usually referred to as a primary laser, and the second light source 2 is usually referred to as a secondary laser.

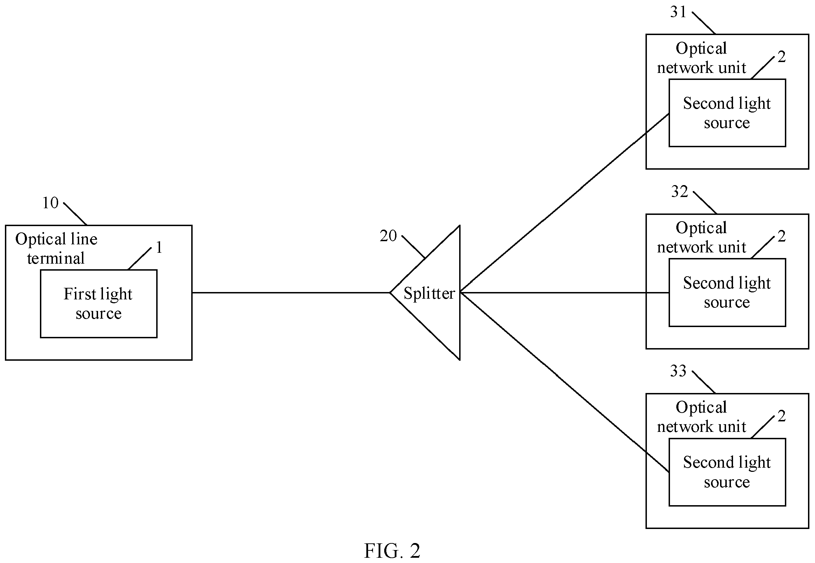

FIG. 2 is a schematic diagram of another application scenario of an optical injection locked system according to this application. The optical injection locked system may be applied to a passive optical network (Passive Optical Network, PON) scenario. Continuous light emitted by an optical line terminal (Optical Line Terminal, OLT) 10 is transmitted to each optical network unit (Optical Network Unit, ONU) by using a splitter 20. A first light source 1 is disposed in the OLT. A second light source 2 is disposed in each of ONUs (31, 32, and 33 shown in FIG. 2). It should be understood that uplink transmission in the PON scenario may be implemented in a CDMA manner, that is, ONUs simultaneously send uplink data to the OLT, and different ONUs correspond to different CDMA codes. To avoid interference when the OLT receives signals transmitted by the ONUs, an optical injection locking technology can be used to enable the ONUs to transmit signals of a same wavelength.

It may be understood that the optical injection locked system may be further applied to another scenario other than the PON scenario. This is not specifically limited in this application. For example, the optical injection locked system may be further applied to a solution of increasing a modulation bandwidth of a second light source. Alternatively, the optical injection locked system may be further applied to a solution of reducing a chirp of a second light source.

It should be noted that, to implement that the wavelength of the continuous light emitted by the second light source is the same as the wavelength of the continuous light emitted by the first light source, it needs to be ensured that a polarization direction of continuous light injected into the second light source is the same as a polarization direction of continuous light generated by the second light source. However, in a transmission process of continuous light emitted by the first light source to the second light source, the polarization direction of the continuous light injected into the second light source may be changed due to impact of an environment.

Therefore, this application provides a light source, to enable a polarization direction of continuous light injected into a local laser of the light source to be the same as a polarization direction of continuous light generated by the local laser. It should be understood that the light source provided in this application is the foregoing second light source, and the continuous light injected into the second light source comes from the foregoing first light source.

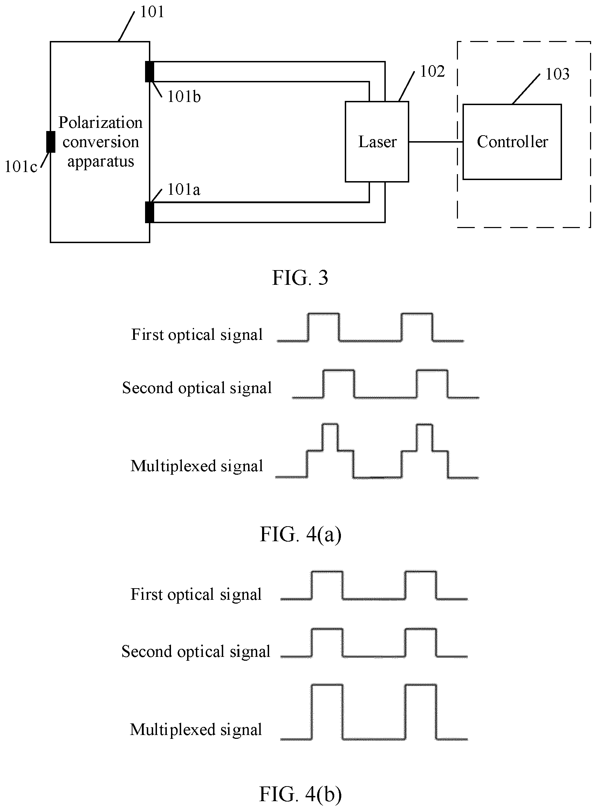

FIG. 3 is a schematic diagram of a first embodiment of a light source according to this application. The light source includes a polarization conversion apparatus 101 and a laser 102. The polarization conversion apparatus 101 includes a port 101a, a port 101b, and a port 101c. The port 101c is configured to receive injected continuous light. The port 101a and the port 101b are coupled to the laser 102 by using different waveguides.

The polarization conversion apparatus 101 is configured to convert the injected continuous light into first continuous light and second continuous light. The first continuous light is output from the port 101a and transmitted to the laser 102 by using a waveguide. The second continuous light is output from the port 101b and transmitted to the laser 102 by using a waveguide. Specifically, the first continuous light and the second continuous light are respectively injected from two different end faces of the laser 102.

It should be understood that a polarization direction of continuous light generated by the laser 102 is set. The injected continuous light may be in any polarization direction. It may be understood that the injected continuous light is formed by combining, based on a specific proportion, two paths of continuous light whose polarization directions are orthogonal to each other. Specifically, the polarization conversion apparatus 101 may split the injected continuous light into two paths. A polarization direction of one path of continuous light is the same as the polarization direction of the continuous light generated by the laser 102, that is, this path of continuous light is the first continuous light. A polarization direction of the other path of continuous light is orthogonal to the polarization direction of the continuous light generated by the laser 102. The polarization conversion apparatus 101 further adjusts the polarization direction of the other path of continuous light to be the same as the polarization direction of the continuous light generated by the laser 102, to obtain the second continuous light.

For example, the laser 102 generates Transverse Electric (Transverse Electric, TE) polarized light. The injected continuous light is formed by combining the TE polarized light and transverse magnetic (Transverse Magnetic, TM) polarized light based on a specific proportion. The polarization conversion apparatus 101 converts the injected continuous light into two paths of TE polarized light. One path of TE polarized light is output from the port 101a, and the other path of TE polarized light is output from the port 101b. It may be understood that if the laser 102 generates TM polarized light, the polarization conversion apparatus may also convert the injected continuous light into two paths of TM polarized light.

The laser 102 is configured to generate first output light and second output light based on the injected continuous light. The first output light and the second output light are respectively emitted from two end faces of the laser 102. The first output light is transmitted from the port 101a to the polarization conversion apparatus 101 by using the waveguide. The second output light is transmitted from the port 101b to the polarization conversion apparatus 101 by using the waveguide. The polarization conversion apparatus 101 is further configured to multiplex the first output light and the second output light, and output, through the port 101c, continuous light after multiplexing. It should be noted that before multiplexing the first output light and the second output light, the polarization conversion apparatus 101 may further adjust polarization directions of the first output light or the second output light, to form mixed polarized continuous light after multiplexing. It should be understood that a wavelength of the first output light, a wavelength of the second output light, and a wavelength of the injected continuous light are the same.

In a possible implementation, a controller 103 is further disposed on a periphery of the light source, and is configured to adjust, based on a power and the wavelength of the injected continuous light, a power and the wavelength of continuous light output by the laser 102. A ratio of the power of the injected continuous light to the power of the continuous light generated by the laser 102 is greater than a preset value, and a difference between the wavelength of the injected continuous light and the wavelength of the continuous light generated by the laser 102 is within a preset range. After the foregoing conditions are met, the continuous light generated by the laser 102 may be wavelength-locked with the injected continuous light. Specifically, a spectrometer may be used to observe whether the wavelength of the continuous light generated by the laser is the same as a wavelength of the first continuous light or a wavelength of the second continuous light. If the wavelengths are different, the power and the wavelength of the continuous light output by the laser 102 continue to be adjusted by the controller 103 until wavelength locking is achieved. It should be noted that the controller 103 may be specifically an electronic chip or a thermoelectric cooler (Thermoelectric Cooler, TEC). The TEC adjusts a power and a wavelength of output light of the laser 102 by changing a temperature of the laser 102. The electronic chip adjusts a power and a wavelength of output light of the laser 102 by changing a current applied to the laser 102.

It should be understood that if the electronic chip loads a direct current on the laser 102, both the first output light and the second output light generated by the laser are continuous light.

Optionally, if the electronic chip loads an electrical signal on the laser 102, both the first output light and the second output light generated by the laser are optical signals. After two optical signals emitted from the two end faces of the laser 102 are transmitted to the polarization conversion apparatus 101, a phase inconsistency problem may occur. For details, refer to FIG. 4 (a) and FIG. 4 (b). FIG. 4 (a) is a schematic diagram of two optical signals whose phases are inconsistent. FIG. 4 (b) is a schematic diagram of two optical signals whose phases are consistent.

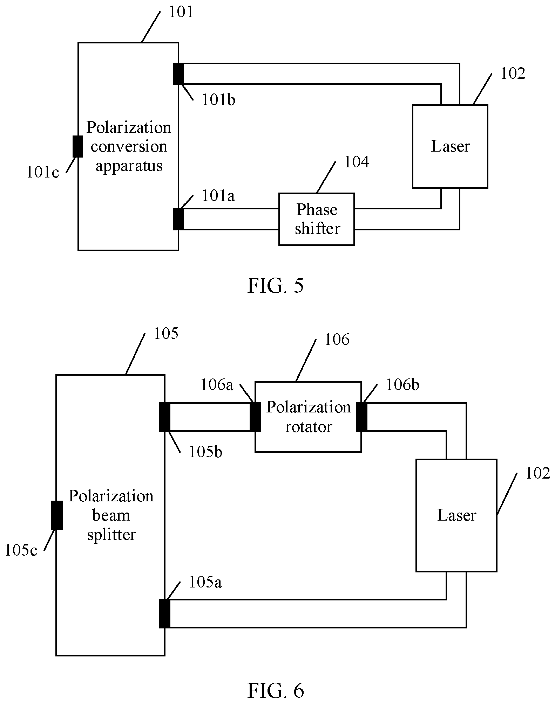

Therefore, a phase shifter (Phase Shifter, PS) needs to be introduced on a transmission path of at least one of the optical signals for phase adjustment on the optical signal, so that the phases of the two optical signals after multiplexing by the polarization conversion apparatus 101 are synchronized. The following provides detailed description with reference to FIG. 5.

FIG. 5 is a schematic diagram of a second embodiment of a light source according to this application. The light source further includes a phase shifter 104. One end of the phase shifter 104 is coupled to the port 101a by using a waveguide, and the other end of the phase shifter 104 is coupled to the laser 102 by using a waveguide. The phase shifter 104 is configured to perform phase adjustment on a first optical signal (the first output light) output by the laser 102. The first optical signal after phase adjustment is input to the polarization conversion apparatus 101 through the port 101a. A second optical signal (the second output light) output by the laser 102 is input to the polarization conversion apparatus 101 through the port 101b. It may be understood that, before the light source is officially put into use, a multiplexed signal output by the polarization conversion apparatus 101 may be observed by using an oscilloscope, and an offset of the phase shifter 104 is pre-calibrated based on an actual observation result, to ensure that phases of the first optical signal and the second optical signal after multiplexing performed by the polarization conversion apparatus 101 are synchronized.

Optionally, the phase shifter 104 may be specifically a heater (Heater). A phase of an optical signal is adjusted by changing a voltage loaded on the heater. Alternatively, the phase shifter may be a PN junction waveguide region. A phase of an optical signal is adjusted by changing an injection current or voltage of the waveguide region.

In addition to the structure shown in FIG. 5, the phase shifter 104 may be disposed on a transmission path of the other optical signal. For example, one end of the phase shifter 104 is coupled to the port 101b by using a waveguide, and the other end of the phase shifter 104 is coupled to the laser 102 by using a waveguide. Alternatively, phase shifters may be disposed on both transmission paths of the two optical signals output by the laser 102. If a fault occurs in one of the phase shifters, the light source can still work normally. It should be understood that the foregoing optional implementations are all based on the structure shown in FIG. 5, and accompanying drawings are not provided herein again.

It should be noted that in actual application, the polarization conversion apparatus 101 has a plurality of specific implementations. First implementation: The polarization conversion apparatus 101 may be specifically a polarization splitter and rotator (Polarization Splitter and Rotator, PSR). For a function of the PSR, refer to the foregoing function description of the polarization conversion apparatus 101. Details are not described herein again. Second implementation: The polarization conversion apparatus 101 includes a polarization beam splitter (Polarization Beam Splitter, PBS) and a polarization rotator (Polarization Rotator, PR). The following provides detailed description with reference to FIG. 6.

FIG. 6 is a schematic diagram of a third embodiment of a light source according to this application. A port 105c of a polarization beam splitter 105 is configured to receive injected continuous light. The polarization beam splitter 105 is configured to convert the injected continuous light into the first continuous light and third continuous light. The polarization direction of the first continuous light is orthogonal to a polarization direction of the third continuous light. The first continuous light is output from a port 105a of the polarization beam splitter 105, and is transmitted to the laser 102 by using a waveguide. The third continuous light is output from a port 105b of the polarization beam splitter 105, and is transmitted from a port 106a to a polarization rotator 106 by using the waveguide. The polarization rotator 106 is configured to adjust the polarization direction of the third continuous light, so that a polarization direction of a second continuous light obtained by converting the third continuous light is the same as the polarization direction of the first continuous light. The second continuous light is output from the port 106b of the polarization rotator 106, and is transmitted to the laser 102 by using a waveguide.

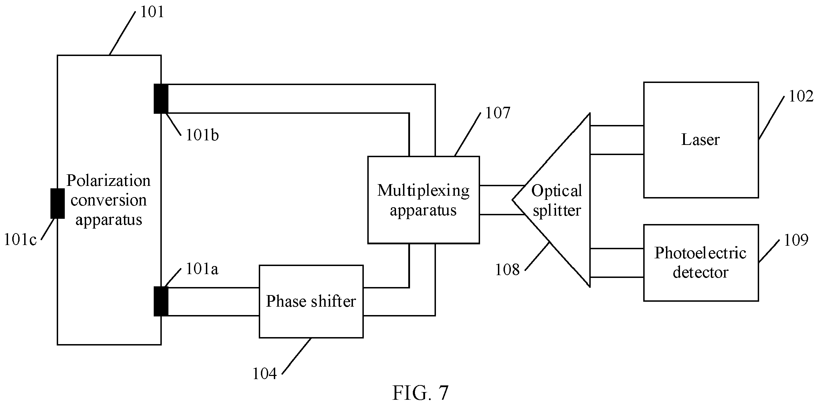

In some possible implementations, before the first continuous light and the second continuous light are injected into the laser 102, further, multiplexing may be first performed on the first continuous light and the second continuous light. The first continuous light and second continuous light after multiplexing are injected from a same end face of the laser 102. FIG. 7 is a schematic diagram of a fourth embodiment of a light source according to this application. The light source may further include the phase shifter 104, a multiplexing apparatus 107, an optical splitter 108, and a photoelectric detector (Photo detector, PD) 109. One end of the phase shifter 104 is coupled to the port 101a by using a waveguide, and the other end of the phase shifter 104 is coupled to one input port of the multiplexing apparatus 107 by using a waveguide. Another input port of the multiplexing apparatus 107 is coupled to the port 101b of the polarization conversion apparatus 101 by using a waveguide. An output port of the multiplexing apparatus 107 is coupled to an input port of the optical splitter 108 by using a waveguide. One output port of the optical splitter 108 is coupled to the laser 102 by using a waveguide. Another output port of the optical splitter 108 is coupled to the photoelectric detector 109 by using a waveguide. The multiplexing apparatus 107 is configured to multiplex the first continuous light and the second continuous light, and transmit continuous light after multiplexing to the optical splitter 108. The optical splitter 108 is configured to split the continuous light after multiplexing. One path of continuous light is transmitted to the laser 102, and the other path of continuous light is transmitted to the photoelectric detector 109. It should be noted that after the first continuous light and the second continuous light are multiplexed, extinction may occur due to interference. Therefore, whether extinction occurs needs to be determined based on a detection result of the photoelectric detector 109. Specifically, if the detection result of the photoelectric detector 109 is 0, it indicates that extinction occurs. Then, a phase of the first continuous light needs to be adjusted by using the phase shifter 104, to prevent extinction after the first continuous light and the second continuous light are multiplexed, thereby ensuring that there can be continuous light to be injected into the laser 102.

It may be understood that, in addition to the structure shown in FIG. 7, the phase shifter 104 may be disposed on a transmission path of the other optical signal. For example, one end of the phase shifter 104 is coupled to the port 101b by using a waveguide, and the other end of the phase shifter 104 is coupled to the another input port of the multiplexing apparatus 107 by using a waveguide.

It should be noted that the polarization conversion apparatus 101 and the laser 102 may use a same substrate, or may use different substrates. The two cases are separately described in the following.

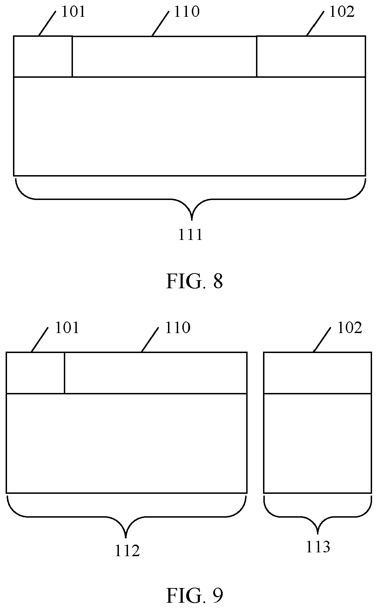

FIG. 8 is a schematic diagram of a cross section of a light source according to this application. As shown in FIG. 8, the polarization conversion apparatus 101, the laser 102, and a waveguide 110 are all grown on a substrate 111. That is, the light source is an integrally formed structure including a substrate. Specifically, the laser 102 needs to be fabricated based on the substrate 111. Then, the polarization conversion apparatus 101 may be further processed on the substrate 111 of the laser 102. It should be noted that the laser 102 is not limited to a part grown on the substrate 111, and the substrate 111 is also a component part of the laser 102. Similarly, the polarization conversion apparatus 101 is not limited to a part grown on the substrate 111, and the substrate 111 is also a component part of the polarization conversion apparatus 101. It should be understood that the waveguide 110 includes two waveguides shown in FIG. 3. The two waveguides may be specifically physically connected to the two end faces of the laser 102. Based on the structure shown in FIG. 8, the light source in this application may be implemented in a form of an integrated chip.

FIG. 9 is a schematic diagram of another cross section of a light source according to this application. As shown in FIG. 9, the polarization conversion apparatus 101 and the waveguide 110 are grown on a substrate 112. The laser 102 is grown on a substrate 113. It should be noted that the laser 102 is not limited to a part grown on the substrate 113, and the substrate 113 is also a component part of the laser 102. Similarly, the polarization conversion apparatus 101 is not limited to a part grown on the substrate 112, and the substrate 112 is also a component part of the polarization conversion apparatus 101. It should be understood that the waveguide 110 includes two waveguides shown in FIG. 3. The two waveguides cannot be physically connected to the two end faces of the laser 102, but are coupled together through air. Based on the structure shown in FIG. 9, the polarization conversion apparatus 101 and the laser 102 in this application may be respectively integrated into two mutually independent chips. The light source in this application may be an integrated component that packages the two chips together.

Optionally, materials of the substrates shown in FIG. 8 and FIG. 9 may be silicon-based semiconductor materials or indium phosphide (InP). If the substrate is the silicon-based semiconductor material, a material of a waveguide grown on the substrate may include at least one of silicon, silicon dioxide, or silicon nitride. If the substrate is the InP material, a material of a waveguide grown on the substrate may include at least one of InP, indium gallium arsenide phosphide (InGaAsP), or indium gallium aluminum arsenide (InGaAlAs).

Optionally, the laser 102 may be a silicon-based laser or a laser of a III-V material. A substrate material that may be used by the silicon-based laser is the silicon-based semiconductor material. A substrate material that may be used by the laser of a III-V material is InP. In addition, the laser of a III-V material may also be bonded to the substrate of the silicon-based semiconductor material. This is not specifically limited herein.

In this embodiment of this application, the polarization conversion apparatus in the light source converts the injected continuous light into the first continuous light and the second continuous light, and transmits the first continuous light and the second continuous light to the laser in the light source by using different waveguides. The polarization direction of the first continuous light, the polarization direction of the second continuous light, and the polarization direction of the continuous light generated by the laser are the same. Therefore, the wavelength of the output light of the laser may be the same as the wavelength of the injected continuous light.

Based on the foregoing description of the light source, the following describes an optical transmission method combined with the light source. It should be noted that an apparatus structure corresponding to the optical transmission method may be as described in the foregoing apparatus embodiment, but is not limited to the light source described above.

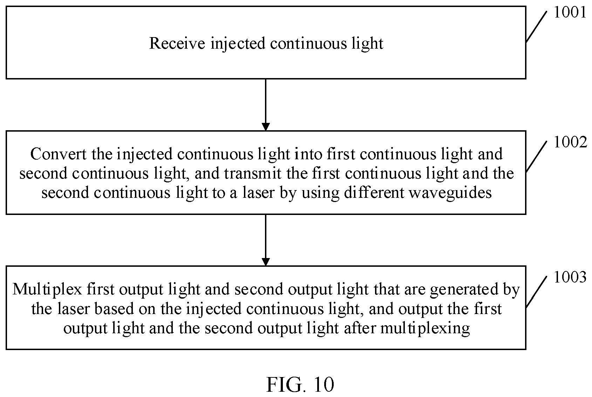

FIG. 10 is a schematic diagram of an embodiment of an optical transmission method according to this application. In this example, the optical transmission method includes the following steps.

1001: Receive injected continuous light.

It should be understood that this embodiment is also applicable to the optical injection locked system shown in FIG. 1 or FIG. 2. The injected continuous light comes from the first light source shown in FIG. 1 or FIG. 2. The second light source shown in FIG. 1 or FIG. 2 is configured to receive the injected continuous light.

1002: Convert the injected continuous light into first continuous light and second continuous light, and transmit the first continuous light and the second continuous light to a laser by using different waveguides.

In this embodiment, the injected continuous light may be in any polarization direction. Polarization directions of the first continuous light and the second continuous light that are obtained through conversion is the same as a polarization direction of continuous light generated by a local laser. For a specific conversion process, refer to a function description of the polarization conversion apparatus in the foregoing apparatus embodiment. Details are not described herein again. It should be noted that the first continuous light and the second continuous light are respectively injected from two different end faces of the laser.

1003: Multiplex first output light and second output light that are generated by the laser based on the injected continuous light, and output the first output light and the second output light after multiplexing.

In this embodiment, a power and a wavelength of continuous light output by the laser may be adjusted based on a power and a wavelength of the injected continuous light, so that a wavelength of the first output light, a wavelength of the second output light, and a wavelength of the injected continuous light are the same. For a specific implementation, refer to the foregoing related description corresponding to FIG. 3. Details are not described herein again. It should be noted that the first output light and the second output light are respectively output from the two different end faces of the laser.

It should be understood that if a direct current is loaded on a laser 102, both the first output light and the second output light generated by the laser are continuous light.

Optionally, if an electrical signal is loaded on the laser 102, both the first output light and the second output light generated by the laser are optical signals. It should be noted that a phase inconsistency problem may occur after a first optical signal (the first output light) and a second optical signal (the second output light) that are emitted from the two end faces of the laser 102 are multiplexed. Therefore, before the first optical signal and the second optical signal are multiplexed, phase adjustment may be further performed on the first optical signal or the second optical signal, so that phases of the first optical signal and the second optical signal after multiplexing are synchronized. For a specific implementation, refer to the foregoing related description corresponding to FIG. 5. Details are not described herein again.

It should be noted that the foregoing embodiments are merely used to describe the technical solutions of this application, but are not limited thereto. Although this application is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of embodiments of this application.

## Claims

1. A light source, wherein the light source comprises a polarization conversion apparatus, a laser, and a plurality of waveguides, the polarization conversion apparatus comprises a first port, a second port, and a third port, and the first port and the second port are coupled to the laser by using different waveguides;
the polarization conversion apparatus is configured to receive injected continuous light through the third port, convert the injected continuous light into first continuous light and second continuous light, transmit the first continuous light to the laser through the first port, and transmit the second continuous light to the laser through the second port, wherein a polarization direction of the first continuous light and a polarization direction of the second continuous light are the same as a polarization direction of continuous light generated by the laser;
the laser is configured to: generate first output light and second output light based on the injected continuous light, transmit the first output light to the polarization conversion apparatus through the first port, and transmit the second output light to the polarization conversion apparatus through the second port, wherein a wavelength of the first output light, a wavelength of the second output light, and a wavelength of the injected continuous light are the same; and
the polarization conversion apparatus is further configured to multiplex the first output light and the second output light, and output, through the third port, the first output light and the second output light after multiplexing.

2. The light source according to claim 1, wherein the first output light and the second output light are both continuous light.

3. The light source according to claim 1, wherein both the first output light and the second output light are optical signals, and the light source further comprises a phase shifter PS; and
an end of the PS is coupled to the laser by using a waveguide, another end of the PS is coupled to the first port by using a waveguide, and the PS is configured to perform phase adjustment on the first output light, and transmit the first output light after the phase adjustment to the polarization conversion apparatus by using the first port, so that phases of the first output light and the second output light after multiplexing are synchronized; or
an end of the PS is coupled to the laser by using a waveguide, another end of the PS is coupled to the second port by using a waveguide, and the PS is configured to perform phase adjustment on the second output light, and transmit the second output light after the phase adjustment to the polarization conversion apparatus by using the second port, so that phases of the first output light and the second output light after multiplexing are synchronized.

4. The light source according to any one of claims 1 to 3, wherein the polarization conversion apparatus is a polarization splitter and rotator PSR.

5. The light source according to any one of claims 1 to 3, wherein the polarization conversion apparatus comprises a polarization beam splitter PBS and a polarization rotator PR, the PBS comprises the first port, the third port, and a fourth port, the PR comprises the second port and a fifth port, and the fourth port and the fifth port are coupled by using the waveguide;
the PBS is configured to convert the injected continuous light into the first continuous light and third continuous light, transmit the first continuous light to the laser through the first port, and transmit the third continuous light to the PR through the second port, wherein the polarization direction of the first continuous light and a polarization direction of the third continuous light are mutually orthogonal; and
the PR is configured to convert the third continuous light into second continuous light, and transmit the second continuous light to the laser.

6. The light source according to any one of claims 1 to 5, wherein the laser comprises a first end face and a second end face, the first continuous light is transmitted to the laser from the first end face, and the second continuous light is transmitted to the laser from the second end face.

7. The light source according to any one of claims 1 to 6, wherein the polarization conversion apparatus, the laser, and the plurality of waveguides share a same substrate; and
a material of the substrate is a silicon-based semiconductor material, and a material of the plurality of waveguides comprises at least one of silicon, silicon dioxide, or silicon nitride; or a material of the substrate is indium phosphide InP, and a material of the plurality of waveguides comprises at least one of InP, indium gallium arsenide phosphide InGaAsP, or indium gallium aluminum arsenide InGaAlAs.

8. The light source according to any one of claims 1 to 6, wherein the polarization conversion apparatus and the plurality of waveguides share a first substrate, and the laser uses a second substrate; and
a material of the first substrate is a silicon-based semiconductor material, and a material of the plurality of waveguides comprises at least one of silicon, silicon dioxide, or silicon nitride, and a material of the second substrate is InP; or a material of the first substrate is InP, and a material of the plurality of waveguides comprises at least one of InP, InGaAsP, or InGaAlAs, and a material of the second substrate is a silicon-based semiconductor material.

9. The light source according to any one of claims 1 to 8, wherein the injected continuous light is from an optical line terminal OLT, and the light source is located in an optical network unit ONU.

10. An optical transmission method, wherein the method comprises:
receiving injected continuous light;
converting the injected continuous light into first continuous light and second continuous light, and transmitting the first continuous light and the second continuous light to a laser through different waveguides, wherein a polarization direction of the first continuous light and a polarization direction of the second continuous light are the same as a polarization direction of continuous light generated by the laser; and
multiplexing first output light and second output light that are generated by the laser based on the injected continuous light, and outputting the first output light and the second output light after multiplexing, wherein a wavelength of the first output light, a wavelength of the second output light, and a wavelength of the injected continuous light are the same.

11. The method according to claim 10, wherein the first output light and the second output light are both continuous light.

12. The method according to claim 10, wherein the first output light and the second output light are both light signals, and before the multiplexing first output light and second output light, the method further comprises:
performing phase adjustment on the first output light or the second output light, so that phases of the first output light and the second output light after multiplexing are synchronized.

13. The method according to any one of claims 10 to 12, wherein the converting the injected continuous light into first continuous light and second continuous light comprises:
converting the injected continuous light into the first continuous light and the second continuous light by using a polarization splitter and rotator PSR.

14. The method according to any one of claims 10 to 12, wherein the converting the continuous light into first continuous light and second continuous light comprises:
converting the continuous light into the first continuous light and third continuous light by using a polarization beam splitter PBS, wherein the polarization direction of the first continuous light and a polarization direction of the third continuous light are mutually orthogonal; and
converting the third continuous light into the second continuous light by using a polarization rotator PR.

15. The method according to any one of claims 10 to 14, wherein the laser comprises a first end face and a second end face, the first continuous light is transmitted to the laser from the first end face, and the second continuous light is transmitted to the laser from the second end face.

16. The method according to any one of claims 10 to 15, wherein the injected continuous light is from an optical line terminal OLT, and the laser is located in an optical network unit ONU.

17. An optical injection locked system, wherein the system comprises a first light source and a second light source, the first light source is configured to emit continuous light to the second light source, and the second light source is the light source according to any one of claims 1 to 9.

18. The system according to claim 17, wherein the first light source is located in an optical line terminal OLT, and the second light source is located in an optical network unit ONU.
